**Europäisches Patentamt**

**European Patent Office**

**Office européen des brevets**

(19)

(11) Veröffentlichungsnummer: **0 054 649**
**A1**

# EUROPÄISCHE PATENTANMELDUNG

(12)

(21) Anmeldenummer: **81108330.2**

(22) Anmeldetag: **14.10.81**

(51) Int. Cl.³: **H 01 L 21/00**

(30) Priorität: **15.12.80 DE 3047140**

(43) Veröffentlichungstag der Anmeldung: **30.06.82**
**Patentblatt 82/26**

(84) Benannte Vertragsstaaten: **DE FR GB IT**

(71) Anmelder: **SIEMENS AKTIENGESELLSCHAFT Berlin und München, Postfach 22 02 61, D-8000 München 22 (DE)**

(72) Erfinder: **Glasl, Andreas, Dipl.-Phys., Otto-Hahn-Strasse 2, D-8013 Haar (DE)**

(54) Verfahren zum Herstellen einer monolithisch integrierten Halbleiterschaltung.

(57) Die Erfindung betrifft ein Verfahren zur Herstellung einer monolithisch integrierten Halbleiterschaltung, bei dem ein unter Verwendung einer ersten Dotierungsmaske vorzunehmender erster Dotierungsprozeß und dann ein unter Verwendung einer zweiten Dotierungsmaske vorzunehmender zweiter Dotierungsprozeß an der gleichen Seite eines scheibenförmigen monokristallinen Halbleiterplättchens durchgeführt wird, wobei aus unterschiedlichem Material bestehende Dotierungsmasken verwendet werden. Das Verfahren soll insbesondere bei der Herstellung von Transistoren in der integrierten Schaltung angewendet werden, wobei eine Verkleinerung des Basis-Bahnwiderstandes und eine Verkürzung der Laufzeiten im Transistor sowie eine Verminderung der parasitären Kapazitäten der pn-Übergänge angestrebt ist. Erfindungsgemäß wird zur Lösung der genannten Probleme vorgeschlagen, daß die beiden Dotierungsprozesse mit wenigstens zum Teil zueinander komplementär ausgebildeten Dotierungsmasken durchgeführt werden.

EP 0 054 649 A1

0054649

Siemens Aktiengesellschaft
Berlin und München

Unser Zeichen
VPA 80 P 1193 E

## Verfahren zum Herstellen einer monolithisch integrierten Halbleiterschaltung

Die Erfindung bezieht sich auf ein Verfahren zum Herstellen einer monolithisch integrierten Halbleiterschaltung, bei dem ein unter Verwendung einer ersten Dotierungsmaske vorzunehmender erster Dotierungsprozeß und dann ein unter Verwendung einer zweiten Dotierungsmaske vorzunehmender zweiter Dotierungsprozeß an derselben Seite eines scheibenförmigen monokristallinen Halbleiterkörpers durchgeführt und dabei aus unterschiedlichem Material bestehende Dotierungsmasken verwendet werden.

Ein solches Verfahren ist in der DE-OS 24 38 256 bzw. in der DE-OS 24 35 905 beschrieben. Als Material für die eine Dotierungsmaske ist dort Siliciumdioxyd und als Material für die zweite Dotierungsmaske Siliciumnitrid genannt. Dabei wird die Eigenschaft ausgenutzt, daß sich Siliciumnitrid als Material für eine Maske zur Erzielung einer lokal begrenzten Oxydationsschicht an der Oberfläche eines Siliciumkristalls und ggf. auch eines Kristalls aus einem anderen Halbleitermaterial bei Verwendung einer thermischen Oxydation der Halbleiteroberfläche eignet. Deshalb wird in den beiden genannten Fällen eine aus Siliciumnitrid bestehende erste Dotierungsmaske zunächst als Schutzmaske zur lokalen Oxydierung einer Siliciumoberfläche verwendet. Die entstandene Oxydschicht wird dann teilweise von der Siliciumoberfläche wieder entfernt und der Rest der Oxydschicht zusammen mit der Siliciumnitridmaske als erste oder auch als zweite Dotierungsmaske verwendet. Gegebenenfalls kann auch die erste Dotierungsmaske lediglich aus Siliciumntrid und die zweite Dotierungsmaske lediglich aus Siliciumdioxyd bebestehen, wobei die Erzeugung der zweiten Maske unter
Verwendung der ersten Dotierungsmaske als Oxydationsmaske erfolgen kann. Dabei läßt sich ggf. durch Verwendung
eines nur auf das Material der einen Maske einwirkenden
Ätzmediums eine Vereinfachung bei der Maskenherstellung
erreichen, weil dann die eine Maske als Ätzmaske für
die Erzeugung der anderen Maske dienen kann.

Der vorliegenden Erfindung liegt jedoch ein anderes Problem zugrunde, das zunächst klargestellt werden soll.

Im Interesse einer Ablaufbeschleunigung beim Betrieb
monolithisch integrierter Halbleiterschaltungen, also
z.B. im Interesse der Verkürzung der Gatterlaufzeiten
bei solchen Bipolarschaltungen, erscheint eine Optimierung folgender Transistorparameter angebracht:
    1.) eine Verkleinerung des Basis-Bahnwiderstandes,
    2.) eine Verkürzung der Laufzeiten im Transistor, und
    3.) eine Reduzierung der parasitären Kapazitäten der
        pn-Übergänge.

Hierzu kann man die Strukturgrößen in der integrierten
Schaltung sowohl in vertikaler als auch in lateraler Beziehung - ggf. ohne Rücksicht auf die an sich gebotenen
Sicherheitsabstände - soweit als möglich reduzieren.

Üblich der für die Herstellung der für die Dotierung der
einzelnen Zonen in dem zu behandelnden Halbleiterkristall
zu verwendenden Dotierungsmasken ist bekanntlich die Anwendung der Photolack-Ätztechnik, also ein lichtoptisches
Strukturierungsverfahren, dessen Anwendbarkeit bekanntlich durch die Wellenlänge des bei der Herstellung der
Photolack-Ätzmaske verwendeten Lichts begrenzt ist. Deshalb ist man bei der Anwendung dieser Technik mit Geometrien von 2,0 - 3,0 $\mu$m Mindestbreite am Ende. Eine weitere Reduzierung ist zwar durch Elektronenstrahl-Belichtung
möglich. Hier ist jedoch, wie bei den anderen zur Verfü-

0054649

gung für eine Unterschreitung der genannten Dimensionsgrenze stehenden Verfahren, wie z.B. bei dem Step- and-
Repeat-Verfahren, ein im Vergleich zu der konventionellen,
d.h. normaler Photolack-Belichtung arbeitenden Strukturierungstechnik ein erheblich größerer technischer Aufwand
zu leisten, wobei der erzielte Gewinn in einem sehr ungünstigen Verhältnis zu dem erhöhten Aufwand steht.

Es ist deshalb Aufgabe der Erfindung, eine Möglichkeit
des eingangs definierten Verfahrens anzugeben, welche
eine über die genannte Grenze hinaus wirksame Strukturverkleinerung ermöglicht und mit nur die konventionellen
lichtoptischen Mittel für die Maskenstrukturierung verwendenden Mitteln zum Ziele gelangt.

Die Erfindung bezieht sich deshalb auf ein Verfahren zum
Herstellen einer monolithisch integrierten Halbleiterschaltung der eingangs definierten Art und ist dadurch
gekennzeichnet,daß in lateraler Beziehung die zweite
Dotierungsmaske inbezug auf die erste Dotierungsmaske
wenigstens zum Teil komplementär ausgebildet wird.

Damit ist es, wie noch gezeigt wird, möglich, minimale
Strukturbreiten von 1,0 - 1,5 /um zu erzeugen. Außerdem
können kleine Bahnwiderstände durch eine entsprechende
Ausgestaltung der zur Herstellung eines Transistors verwendeten beiden Dotierungsmasken erreicht werden, weil
dann eine Entkopplung der inneren Basis (d.h. des unmittelbar am pn-Übergang zum Emitter (oder bei invertierten
Transistorstrukturen zum Kolektor)) liegenden Bereiches
der Basiszone und der sog. äußeren Basis möglich ist.
Zugleich wird auch eine Verbesserung der inneren
Transistoreigenschaften und eine Reduktion der parasitären Emitter-Basis-Kapazität erreicht.

Gleichzeitig ergeben sich bei Anwendung des erfindungsgemäßen Verfahrens Vorteile hinsichtlich der Herstellbarkeit

0054649
VPA 80 P 1193 E

und Ausbeute. Besonders hervorzuheben ist dabei eine Verbesserung der Oberflächenplanität der Kontaktzonen bei den erhaltenen Halbleiterstrukturen sowie eine deutliche Reduzierung der Gefahr des Auftretens lateraler Basis-Emitterkurzschlüsse im Vergleich zu den auf übliche Weise erhaltenen und mit feinsten Strukturen versehenen monolithisch integrierten Halbleiterschaltungen mit analogem Aufbau.

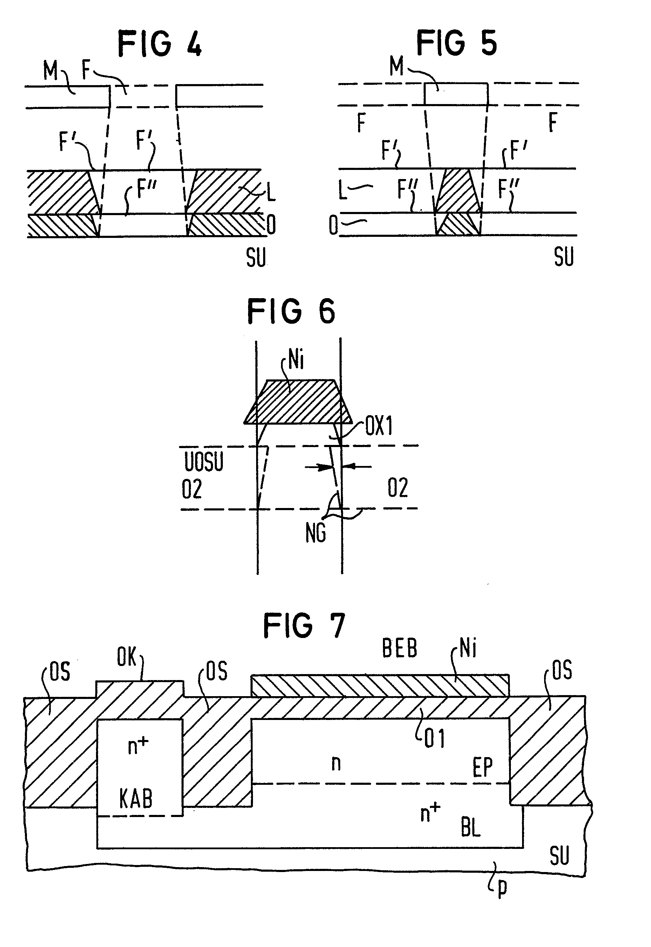

Bevorzugt besteht bei dem erfindungsgemäßen Verfahren die eine Dotierungsmaske aus Siliciumdioxyd und die andere Dotierungsmaske aus Siliciumnitrid, obwohl gelegentlich auch andere anorganische Isoliermaterialien, wie z.B. $Al_2O_3$ als Maskenmaterial eingesetzt werden können. Besteht das Halbleiterplättchen, wie zumeist, aus Silicium, so empfiehlt sich aus bekannten Gründen die Anwendung einer dünnen Pufferschicht aus $SiO_2$ zwischen der Oberfläche des Halbleiterplättchens und einer nicht aus $SiO_2$ bzw. dem Material des Halbleiterplättchens (also z.B. aus polykristallinem Silicium) bestehenden Maskenschicht. Deshalb wird eine solche Pufferschicht bei dem erfindungsgemäßen Verfahren bevorzugt auch zwischen einer aus Siliciumnitrid und der Oberfläche eines aus monokristallinem Silicium bestehenden und dem Verfahren zu unterwerfenden Halbleiterplättchens angeordnet. Die Stärke der Pufferschicht wird dabei in der Regel merklich kleiner als die Stärke einer aus $SiO_2$ bestehenden Dotierungsmaske eingestellt. Eine solche Pufferschicht dient im vorliegenden Fall nicht nur zur Kompensation der Wirkung des Unterschiedes der thermischen Ausdehnungskoeffizienten von Silicium und Siliciumnitrid und der daraus resultierenden Verspannung an der Oberfläche des Halbleiterplättchens sondern zeitigt im vorliegenden Fall, wie noch anhand der Figuren 4 bis 6 gezeigt wird, im Sinne der Erfindung besonders vorteilhafte Wirkungen.

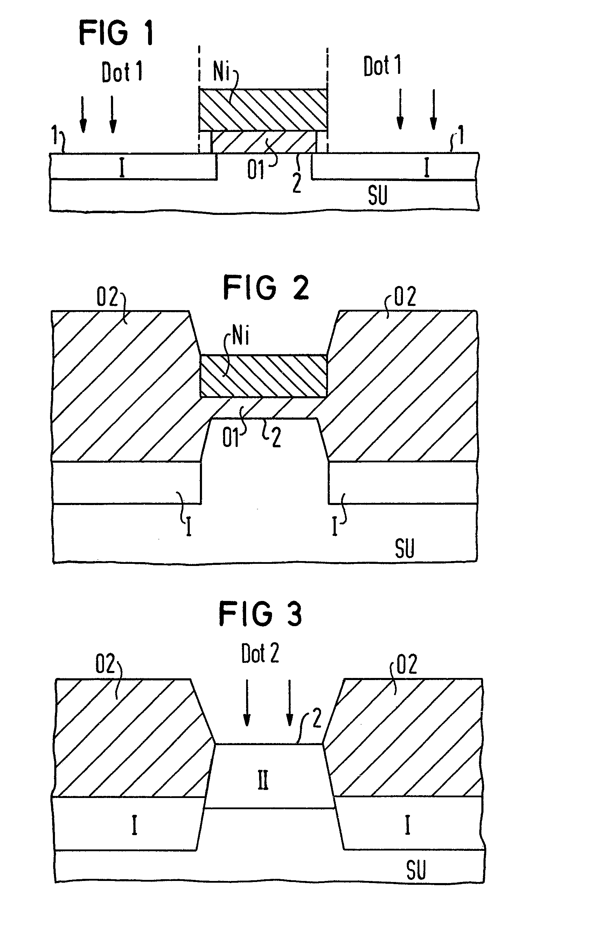

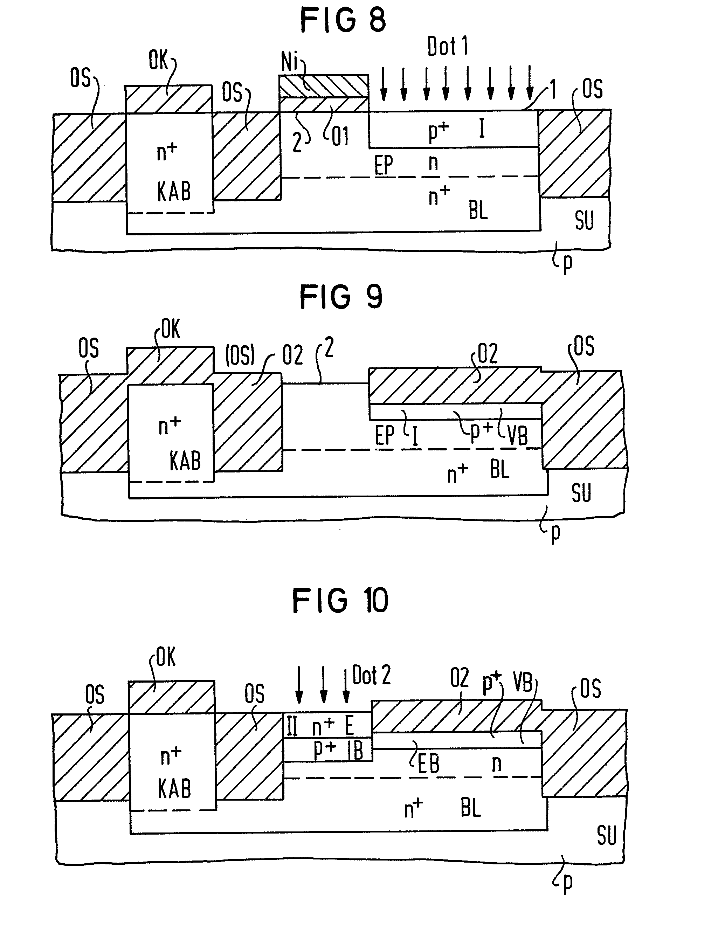

Die Erfindung wird nun anhand der Figuren 1 bis 16 näher beschrieben Die Figuren 1 bis 7 dienen der allgemeinen Erläuterung des erfindungsgemäßen Verfahrens sowie dessen prinzipieller Wirkung, während in den übrigen Figuren 8 bis 16 zwei vorteilhafte Möglichkeiten zur Herstellung vertikaler Bipolartransistoren unter Verwendung des erfindungsgemäßen Verfahrens dargestellt sind.

In der nun folgenden Beschreibung der Erfindung ist der monokristalline scheibenförmige Halbleiterkörper als Substrat bezeichnet und mit dem Bezugszeichen SU versehen. Er besteht aus dotiertem monokristallinem Silicium, z.B. vom p-Typ. Ferner besteht die für den ersten Dotierungsprozeß anzuwendende erste Dotierungsmaske aus einer Siliciumnitridschicht Ni, die auf einer dünnen Pufferschicht aus $SiO_2$ an der Substratoberfläche angeordnet wird. Die Pufferschicht hat das Bezugszeichen 01. Die für den zweiten Dotierungsprozß anzuwendende zweite Dotierungsmaske 02 besteht aus einer Siliciumdioxydschicht.

Bei der unter den soeben dargelegten Gesichtspunkten vorzunehmenden bevorzugten Ausführungsform des erfindungsgemäßen Verfahrens wird als erster Schritt an der zu behandelnden Substratoberfläche eine dünne, z.B. 50 nm starke, $SiO_2$-Schicht 01 erzeugt, die die Grundlage der Pufferschicht bildet. Auf der $SiO_2$-Schicht wird dann die die Grundlage der ersten Dotierungsmaske Ni bildende $Si_3N_4$-Schicht - z.B. durch pyrolythische Abscheidung aus einem geeigneten Reaktionsgas oder durch Aufsputtern - abgeschieden. Dann wird unter Verwendung einer entsprechend geformten Maske, z.B. aus Photolack, und unter Verwendung eines selektiv auf das Material der $Si_3N_4$-Schicht einwirkenden bekannten Ätzverfahrens aus der Siliciumnitridschicht die für den ersten Dotierungsprozeß Dot 1 zu verwendende erste Dotierungsmaske Ni geformt. Mit einem selektiv auf $SiO_2$ einwirkenden aber das Material der Siliciumnitridmaske Ni nicht angreifenden bekannten Ätzmittel (z.B. verdünnte Flußsäure) und unter Verwendung der soeben erhaltenen $Si_3N_4$-Dotierungsmaske als Ätzmaske wird dann auch die **zuerst** erzeugte Oxydschicht von der Substratoberfläche in der Umgebung der Nitrid-Dotierungsmaske Ni entfernt, wobei zwangsläufig die Nitridmaske Ni geringfügig unterätzt wird. Der Grad der Unterätzung hängt von der Stärke der Pufferschicht O1 ab und wird umso größer, je konzentrierter das Ätzmittel und je stärker die zu entfernende Oxydschicht, also die Pufferschicht O1 ist. Hinsichtlich der Durchführung des der Entfernung der nicht benötigten Teile der Oxydschicht O1 dienenden Ätzprozesses ist noch zu erwähnen, daß dieser so zu steuern ist, daß auch das Substrat SU nicht angegriffen wird, weil sonst die Nitridmaske Ni zu stark unterätzt werden würde.

Der nach der Formung der ersten Dotierungsmaske Ni und der sie tragenden Pufferschicht O1 vorliegende Zustand an der zu behandelnden Substratoberfläche ist in Fig. 1 dargestellt. Wie ferner aus Fig. 1 ersichtlich, wird nun der nicht von der ersten Dotierungsmaske abgeschirmte Teil 1 der Substratoberfläche dem ersten Dotierungsprozeß unterzogen, wobei an diesem Teil 1 der Substratoberfläche eine erste umdotierte Zone I entsteht.

Als Alternative zu dem soeben beschriebenen Vorgehen kann man unter Anwendung eines geeigneten Dotierungsverfahrens (Ionenimplantation) den Dotierungsstoff im ersten Dotierungsprozeß Dot1 durch die dünne Oxydschicht hindurch in das Substrat SU einbringen.

Die unmittelbar nach dem ersten Dotierungsprozeß Dot1 vorliegende und aus Fig. 1 ersichtliche Struktur wird nun einem der Erzeugung der zweiten Dotierungsmaske O2 dienenden Oxydationsprozeß unterzogen. Bei diesem werden die Oxydationsbedingungen in bekannter Weise derart eingestellt, daß die Nitridmaske Ni ihre Fähigkeit, als Oxydationsmaske zu wirken entfalten kannd.h. also daß sie nicht selbst oxydiert wird. Geeignete Oxydationsbedingungen sind z.B. durch die Verwendung von Wasserdampf als Oxydationsmittel und einer Behandlungstemperatur von 700 bis 900° und einem Druck des Behandlungsgases von etwa 10-30 Atm gegeben. Wichtig ist, daß der Oxydationsprozeß so durchgeführt wird, daß die vom ersten Dotierungsprozeß herrührende umdotierte Zone I in dem beabsichtigten Umfang erhalten bleibt. Die entstandene Oxydschicht O2 bildet die Grundlage der für den zweiten Dotierungsprozeß benötigten zweiten Dotierungsmaske O2. (Fig. 2).

Der nun folgende Arbeitsschritt dient der Entfernung der ersten Dotierungsmaske Ni unter Verwendung eines die Siliciumdioxydschicht O1 wenig oder überhaupt nicht angreifenden Ätzmittels (z.B. heiße Orthophosphorsäure) Die sich zwischen der Nitridmaske Ni und der Oberfläche des Substrats SU befindliche und aus $SiO_2$ bestehende dünne Pufferschicht O1 wird in einem nachgeschalteten, mit verdünnter Flußsäure oder auf andere bekannte Weise vorzunehmenden Ätzprozeß ebenfalls von der Oberfläche des Bereiches 2 der Substratoberfläche entfernt.

Da man in bekannter Weise die Stärke der die zweite Dotierungsmaske bildenden $SiO_2$-Schicht wesentlich größer als die Stärke der Pufferschicht O1 einstellt, wird bei diesem nachgeschalteten Ätzprozeß auch bei Verwendung eines selektiv auf $SiO_2$ wirkenden Ätzmittels die die zweite Dotierungsmaske O2 bildende Oxydschicht nur unwesentlich angegriffen. Ein Angriff auf die Oberfläche des Substrats läßt sich dabei ebenfalls ohne Schwierigkeiten vermeiden, da wässrige Flußsäure bei Normaltemperatur das aus Silicium bestehende Substrat nicht angreift. Der erhaltene Zustand ist in Fig. 3 dargestellt.

Die nunmehr perfekt vorliegende Maske O2 für den zweiten Dotierungsprozeß Dot2 ist in lateraler Beziehung prak-

0054649

tisch komplementär zur ersten Dotierungsmaske Ni. Eine absolut komplementäre Geometrie zwischen den beiden Dotierungsmasken liegt ersichtlich dann vor, wenn man von der Verwendung der dünnen Pufferschicht ganz absieht oder den zweiten Dotierungsprozeß Dot 2 durch die Pufferschicht O1 hindurch, z.B. unter Verwendung von Ionenimplantation, vornimmt.

Das Ergebnis des erfindungsgemäßen Verfahrens ist in jedem Fall, daß die lateralen Abmessungen der durch den zweiten Dotierungsprozeß Dot2 entstehenden umdotierten Zone II geometrisch viel genauer an die Geometrie des Dotierungsfensters in der zweiten Dotierungsmaske O2 angepaßt ist, als dies ohne den ersten Dotierungsprozeß Dot1 und der zu seiner Durchführung verwendeten ersten Dotierungsmaske Ni der Fall wäre.

Verständlicher Weise besteht die Möglichkeit, das erfindungsgemäße Verfahren mehrmals hintereinander anzuwenden. Im allgemeinen wird dies jedoch nicht erforderlich sein, da, wie noch anhand der Fig. 7 bis 16 gezeigt wird, auch die Herstellung eines bipolaren Vertikaltransistors in platzsparender Weise nur unter einmaliger Anwendung des erfindungsgemäßen Verfahrens gelingt.

Die von der Erfindung angestrebte Verminderung der unteren Grenze für die Dimensionierung der herzustellenden umdotierten Zone II an der Oberfläche des Substrats SU ist vor allem darauf zurückzuführen, daß bei dem erfindungsgemäßen Verfahren die Grenze der im im zweiten Dotierungsprozeß Dot2 entstehenden umdotierten Zone II gegen ihre Umgebung wesentlich besser an die Dimensionierung des zu ihrer Entstehung führenden Fensters in der Dotierungsmaske O2 im Vergleich zu den Verhältnissen bei den üblichen Verfahren auch dann noch angepaßt ist, wenn die Dimensionierung dieses Fensters den mit den üblichen Methoden, also auch mit der üblichen Photolack-

technik erreichbaren kleinsten Dimensionen entspricht.
Dies wird nun anhand der Figuren 4, 5 und 6 verständlich
gemacht.

In Fig. 4 sind die Verhältnisse bei dem üblichen Verfahren zur Herstellung einer umdotierten Zone an der Oberfläche des Substrats SU dargestellt. Fig. 6 zeigt die Verhältnisse beim ersten Dotierungsprozeß und Fig. 7 die Verhältnisse bei dem darauffolgenden zweiten Dotierungsprozeß bei einem Verfahren gemäß der Erfindung.

Wie aus Fig. 4 ersichtlich ist, wird bei dem üblichen Dotierungsverfahren unter Verwendung einer ein Fenster F aufweisenden Belichtungsmaske M zwecks Formung der aus einer Oxydschicht O zu erzeugenden Dotierungsmaske eine auf der Oxydschicht O aufgebrachte Schicht L aus Positiv-Photolack lokal belichtet. Aufgrund der optischen Eigenschaften des die Photolackschicht belichtenden Strahles (Beugung am Rand des Belichtungsfensters F) erhält dessen Begrenzung einen divergierenden Verlauf, so daß das Fenster F', das aufgrund der Belichtung nach dem Entwickeln in der Photolackmaske L vorliegt prinzipiell größere Dimensionen als das Fenster F in der Belichtungsmaske M erhält. Bei der Erzeugung des Dotierungsfensters F" in der als Grundlage für die Dotierungsmaske dienenden Oxydschicht O unter Verwendung der Photolackmaske L als Ätzmaske erfolgt abermals eine Aufweitung, so daß das schließlich erhaltene Dotierungsfenster F" noch größere Dimensionen im Vergleich zu den Dimensionen des Belichtungsfensters F erhält.

Verwendet man hingegen als Maske eine Insel, so führt die Lichtbeugung am Rande der Maske zu einer Konvergenz des die Photolackschicht belichtenden Strahles, wie dies in Fig. 5 gezeigt ist. Die aus der Photolackschicht L dann entstehende inselartige Ätzmaske wird dann als Ätzmaske bei der Formung der Dotierungsmaske verwendet. Man erkennt nun, daß auch bei absoluter Übereinstimmung der Geometrie des Belichtungsfensters F mit der Geometrie der inselartigen Belichtungsmaske M in Fig. 5, die in der als Ätzmaske zu verwendenden Photolackschicht L erhaltenen Ätzgeometrien keinesfalls übereinstimmende Geometrien ihrer Umrandungen erhalten. Man erkennt außerdem, daß die aufgrund des üblichen Verfahrens erhaltenen umdotierten Zonen selbst bei Anwendung von Maßnahmen, welche die laterale Dimension unter den Rändern der Dotierungsmaske reduzieren (z.B. durch Anwendung von Ionenimplantation als Dotierungsverfahren) immer größer werden, als es der Geometrie des für die Erzeugung der Dotierungsmaske verwendeten Belichtungsfensters entspricht.

Der der Erfindung zugrunde liegende Gedanke ist nun, z.B. zur Formung eines pn-Übergangs zwei z.B. mit entgegengesetzt dotierendem Aktivatormaterial vorzunehmende Dotierungsprozesse unter Verwendung zweier komplementärer Dotierungsmasken Ni und O2 vorzunehmen, um dadurch die aus Fig. 4 und 5 ersichtlichen Effekte im Sinne einer Kompensation zu kombinieren (Fig. 6).

Eine weitere Verbesserung in der gewünschten Richtung läßt sich erreichen, wenn man, wie bereits oben angegeben, das Material der aus $SiO_2$ bestehenden zweiten Dotierungsmaske O2 durch Oxydation der nicht durch die erste Dotierungsmaske Ni abgedeckten Stellen 2 der Oberfläche des Substrats SU erzeugt, wobei man, wie bereits angegeben, die Temperaturbelastung der zu behandelnden Anordnung möglichst gering einstellt. Geeignet ist hierfür das bekannte High-Pressure-Verfahren oder eine anodische Oxydation.

Man erkennt nun aus Fig. 6, daß der zur Erzeugung der zweiten Dotierungsmaske O2 dienende Oxydationsschritt zur Oxydation der Oberfläche des Substrats SU auf einen schmalen Randbereich unter der beim ersten Dotierungs-

0054649

prozeß Dot als Dotierungsmaske und bei dem besagten Oxydationsprozeß als Oxydationsmaske verwendeten Nitridmaske
übergreift, so daß der aus Fig. 5 und Fig. 6 ersichtliche
Effekt dann eine weitere Unterstützung erfährt. Die in
Fig. 6 eingezeichnete Linie UOSU bedeutet die unmittelbare Grenze zwischen dem $SiO_2$ und dem Substrat SU, wie
sie vor der Erzeugung der Oxydmaske 02 und NG dieselbe
Grenze, wie sie nach der Erzeugung der Oxydmaske 02 vorliegt.

Eine erste vorteilhafte Variation des erfindungsgemäßen
Verfahrens zur Erzeugung eines npn-Transistors wird nun
anhand der Figuren 7 bis 11 beschrieben.

Zunächst gilt es bei diesem Verfahren, die in Fig. 7
dargestellte Ausgangsstruktur an der Oberfläche des Substrats SU zu erzeugen. Wie üblich wird hierzu zunächst
an der Oberfläche des aus p-dotiertem Silicium bestehenden monokristallinen Substrats eine den Bereich des zu
erzeugenden Transistors an der Substratoberfläche festlegende hochdotierte buried-layer-Zone BL, im vorliegenden Fall vom $n^+$-Typ, durch lokale Umdotierung in bekannter Weise erzeugt. Dann wird die buried-layer-Zone BL in
üblicher Weise mit einer denselben Leitungstyp aber mit
geringerer Dotierungskonzentration aufweisenden monokristallinen Siliciumschicht , also mit einer n-dotierten epitaktischen Siliciumschicht, in bekannter Weise abgedeckt. Im Bereich der epitaktischen Siliciumschicht
wird dann unter Anwendung des erfindungsgemäßen Verfahrens der gewünschte npn-Transistor erzeugt.

Hierzu wird z.B. unter Verwendung der üblichen Oxyd-Isolationstechnik die epitaktische Schicht in inselartige
Einzelbereiche unterteilt, die zur Aufnahme der einzelnen
die herzustellende Schaltung bildenden Elemente, insbesondere der einzelnen Transistoren, bestimmt sind.

Ein auf diese Weise entstandener und mit $SiO_2$ ausgefüllter Isolationsgraben umgrenzt dann nicht nur den für den Transistor vorgesehenen Bereich in der n-dotierten epitaktischen Schicht, sondern trennt auch in diesem Bereich einen bis zur buried-layer-Zone BL reichenden und für die Kontaktierung des Kollektors vorgesehenen Bereich KAB von dem den übrigen Transistor aufnehmenden und ebenfalls bis zur buried-layer-Zone BL reichenden Bereich EP ab.

Dann wird die Oberfläche des Kollektor-Kontaktierungsbereiches KAB von der sie bedeckenden Oxydationsmaske und der darunterliegenden Oxydschicht befreit, während der andere dem herzustellenden Transistor zugeordnete Teil EP der epitaktischen n-dotierten Schicht von der Oxydationsmaske SN noch bedeckt bleibt. Ein nun folgender und mit Donatormaterial durchzuführender Dotierungsprozeß dient zur Erhöhung der Dotierungskonzentration im Kollektor-Kontaktierungsbereich KAB, so daß dieser bis an die Grenze zur buried-layer-Zone BL $n^+$-dotiert wird.

Schließlich wird die freie Oberfläche unter Beibehaltung des bisherigen Zustandes an der Oberfläche der übrigen Teile der Anordnung, also insbesondere an der Oberfläche des Teiles EP der epitaktischen Schicht, wieder oxydiert. Damit ist der in Fig. 7 dargestellte Ausgangszustand der dem erfindungsgemäßen Verfahren zu unterwerfenden Halbleiteranordnung erreicht. Wesentlich für das erfindungsgemäße Verfahren ist das Vorhandensein einer Siliciumnitridschicht SN und einer darunter befindlichen und als Pufferschicht vorgesehenen dünnen $SiO_2$-Schicht 01 an der Oberfläche des Teiles EP der epitaktischen Schicht. Es ist deshalb zweckmäßig, wenn man für die Erzeugung der Isolationsgräben OS eine Oxydationsmaske verwendet, die aus den beiden Schichten SN und 01, also einer Nitridschicht und einer $SiO_2$-Zwischenschicht, besteht. Diese wird dann zunächst an den zur Erzeugung der Isolationsgräben vorgesehenen Stellen der epitaktischen Siliciumschicht entfernt, während die noch vorhandenen Teile als Oxydationsmaske bei der Herstellung der oxyderfüllten Isolationsgräben dienen. Dann wird zwecks der Erhöhung der Dotierungskonzentration in dem Kollektor-Kontaktierungsbereich dessen Oberfläche von der sie noch bedeckenden Nitrid-Oxyd-Kombinationsschicht befreit und nach erfolgter Erhöhung der genannten Dotierungskonzentration durch den bereits erwähnten neuen Oxydationsprozeß durch eine neue Oxydschicht OK ersetzt.

Von diesem, wie bereits erwähnt, in Fig. 7 dargestellten Zustand geht nun das erfindungsgemäße Verfahren aus, indem aus dem an der Oberfläche des für die Aufnahme des Emitters und der Basis des herzustellenden Transistors vorgesehenen Teils EP der n-dotierten epitaktischen Schicht noch vorhandenen Oxydationsmaske SN, 01 die erste Dotierungsmaske gemäß der Definition der Erfindung hergestellt wird. Dies geschieht derart, daß die erste Dotierungsmaske Ni sich über dem für die Emitterzone vorgesehenen Teil der Oberfläche des Teiles EP der n-dotierten epitaktischen Schicht befindet. Außerdem wird der erste Dotierungsprozeß gemäß der Definition der Erfindung hier mit einem den Leitungstyp der Basiszone erzeugenden Aktivator, also im vorliegenden Fall mit einem Akzeptor, z.B. Bor, durchgeführt.

Im Beispielsfalle gemäß Fig. 8 liegt der Emitterbereich des zu erzeugenden Transistors unmittelbar neben demjenigen Teil des oxyderfüllten Isolationsgrabens OS, der den dem zu erzeugenden Transistor zugeteilten Bereich der epitaktischen Schicht in die beiden Teile KAB und EP trennt. Dies bedeutet, daß für den ersten Dotierungsprozeß als Dotierungsmaske zusätzlich zu dem den Emitterbereich abdeckenden Teil Ni der ersten Oxydationsmaske zusätzlich noch das in den Isolationsgräben vorhandene Isolationsoxyd OS und die Oxydabdeckung OK an der Oberfläche des Kollektor-Kontaktierungsbereichs KAB als weitere ( wenn auch für die durch das erfindungsgemäße Verfahren angestrebte Wirkung 'unbedeutende) Teile der ersten Dotierungsmaske vorhanden sind.

Wie aus Fig. 8 ersichtlich ist, wird dem ersten Dotierungprozeß gemäß der Definition der Erfindung bei der vorliegenden Variante des erfindungsgemäßen Verfahrens der an die Halbleiteroberfläche grenzende Teil VB der Basiszone an dem nicht für den Emitter vorgesehenen Oberflächenteil der epitaktischen Schicht EP hergestellt. Dabei wird der erste Dotierungsprozeß nur solange durchgeführt, daß die durch ihn entstehende $p^+$-dotierte Zone VB die buried-layer-Zone BL nirgends erreicht. Es existiert somit, wie aus Fig. 8 ersichtlich, auch nach dem ersten Dotierungsprozeß noch ein zwischen der Zone VB und dem Bereich BL liegender Zwischenbereich mit der unveränderten Dotierung der epitaktischen Schicht EP.

Die Oberfläche der in Fig. 8 dargestellten und aufgrund des ersten Dotierungsprozesses Dot1 entstandenen Anordnung wird nun unter Verwendung der ersten Dotierungsmaske in deren bisher vorliegenden Form als Oxydationsmaske mit der für den zweiten Dotierungsprozeß gemäß der Definition der Erfindung benötigten Dotierungsmaske durch lokale Oxydation der Oberfläche der epitaktischen Schicht im Bereich der aufgrund des ersten Oxydationsprozesses entstandenen $p^+$-dotierten Zone VB versehen. Der zur Entstehung der zweiten Dotierungsmaske O2 führende Oxydationsprozeß an dem Oberflächenteil 1 des Teiles EP der epitaktischen Schicht läßt verständlicherweise einen Teil der umdotierten Zone VB vom ersten Dotierungsprozeß Dot1 bestehen. Die Stärke der als zweite Dotierungsmaske einzusetzenden Oxydschicht O2 ist derart auf die Tiefe der an dem Oberflächenteil O1 zu erzeugenden Emitterzone abzustimmen, daß deren pn-Übergang etwas weiter als die Oxydschicht O2 in die epitaktische Schicht EP hineinreicht.

In dem nun folgenden Schritt des erfindungsgemäßen Verfahrens wird nun die erste Dotierungsmaske Ni unter Verwendung der Oxydteile O2, OK und OS als Ätzmaske und unter Verwendung von heißer $H_3PO_4$ als Ätzmittel oder auf eine sonstige bekannte Weise selektiv entfernt und der zur Aufnahme der Emitterzone des herzustellenden Transistors vorgesehene Teil 2 der Oberfläche des Teiles EP der epitaktischen Schicht für den zweiten Dotierungsprozeß gemäß der Definition der Erfindung freigelegt. Damit entsteht die aus Fig. 9 ersichtliche Struktur der behandelten Anordnung. Diese wird nun dem zweiten Dotierungsprozeß gemäß der Definition der Erfindung Dot2 unterworfen. Dieser führt zur Entstehung des $n^+$-dotierten Emitters E, während die sog. innere Basis IB durch einen dritten Dotierungsprozeß erzeugt wird. Der Emitter E wird im Beispielfall durch Eindiffundieren von Donatormaterial und die innere Basis durch Implantieren von Akzeptormaterial unter Verwendung der unveränderten zweiten Dotierungsmaske als Implantationsmaske erzeugt. Der erreichte Zustand ist in Fig. 10 gezeigt.

Ersichtlich kann man sowohl den Emitter E als auch die innere Basis IB des Transistors als umdotierte Zonen II und die beiden zu ihrer Entstehung führenden Dotierungsprozesse als zweiten Dotierungsprozeß Dot2 im Sinne der vorliegenden Erfindung auffassen. Ferner ist es verständlich, daß der anhand der Fig. 4, 5 und 6 erläuterte Effekt immer dann bei dieser Variante des erfindungsgemäßen Verfahrens wirksam ist, wenn wenigstens einer durch diese Dotierungsprozesse entstandener pn-Übergang tiefer in die epitaktische Schicht EP hineinreicht als die zweite Dotierungsmaske O2. Zu bemerken ist, daß auch zwischen der inneren Basis IB und der buried-layer-Zone BL noch ein unveränderter, also den ursprünglichen Dotierungszustand der epitaktischen Schicht EP, also eine Zone vom n-Typ, verbleibt. Diese bildet den Kollektor K des Transistors, der über die buried-layer-Zone BL und über den Kollektor-Kontaktierungsbereich KAB zu kontaktieren ist. Hierzu wird ein Teil der Oberfläche der beim ersten Dotierungsprozeß Dot 1 entstandenen $p^+$-Zone VB von der sie bedeckenden Oxydschicht O2 befreit und an der freigelegten Stelle ein Basiskontakt BK erzeugt. Außerdem wird die Kollektor-Kontaktierungszone KAB wieder freigelegt und mit einem Kollektorkontakt KK versehen. Schließlich wird an der freien Oberfläche der Emitterzone E eine Emitterelektrode aufgebracht. Die Kontaktierung der drei Zonen K, VB und E kann in einem gemeinsamen Schritt erfolgen.

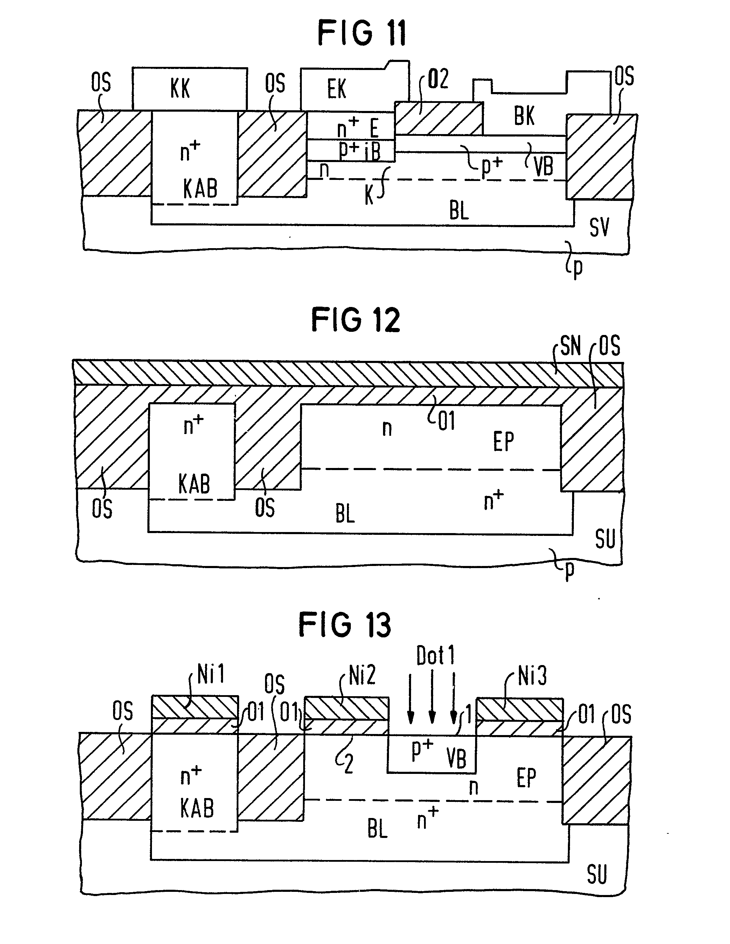

Zu erwähnen ist noch, daß bei dem beschriebenen Verfahren die Reihenfolge der Erzeugung der inneren Basis IB und der Emitterzone E vertauscht werden kann. Der bei dem beschriebenen Verfahren erreichte Endzustand, also der fertige Transistor ist in Fig. 11 dargestellt.

Das anhand der Figuren 7 - 11 beschriebene Verfahren eignet sich vor allem für die Herstellung von Transistoren, die für besonders rasch arbeitende logische Schaltungen benötigt werden. Eine andere besonders vorteilhafte Ausgestaltung des erfindungsgemäßen Verfahrens bei der Herstellung eines Transistors wird nun anhand der Figuren 12 bis 16 gezeigt.

Um zu dem aus Fig. 12 ersichtlichen Ausgangszustand für die nun zu beschreibende Variante des erfindungsgemäßen Verfahrens zu gelangen, wird man zunächst entsprechend den oben dargelegten Details die Oberfläche einer p-dotierten monokristallinen Siliciumscheibe SU mit der $n^+$-dotierten buried-layer-Zone BL versehen und dann diese mit der n-dotierten epitaktischen Siliciumschicht abdecken. Diese wird dann in gleicher Weise, wie oben beschrieben, mit den das Areal des zu erzeugenden Transistors festlegenden und dieses Areal in die beiden Be-

0054649

reiche EP und KAB unterteilenden oxyderfüllten Isolationsgräben OS versehen. Schließlich wird die zur Erzeugung.
der Isolationsgräben verwendete Oxydationsmaske nach erfolgter Verstärkung der Dotierung in dem Kollektor-Kontaktierungsbereich KAB entfernt und die mit Ausnahme der oxyderfüllten Isolationsgräben OS dann freigelegte Oberfläche
der epitaktischen Schicht mit einer durchgehenden ersten
Oxydschicht O1 und diese mit einer durchgehenden Nitridschicht SN bedeckt. Damit ist der in Fig. 12 gezeigte Ausgangszustand für die Durchführung des erfindungsgemäßen
Verfahrens erreicht.

Nunmehr wird zur Herstellung der ersten Dotierungsmaske
gemäß der Definition des erfindungsgemäßen Verfahrens die
Siliciumnitridschicht SN mittels Photolack-Ätztechnik in
drei Teile Ni1, Ni2 und Ni3 unterteilt, wobei der Teil
Ni1 die Oberfläche des Kollektor-Kontaktierungsbereichs
KAB bedeckt, der Teil Ni2 der Abdeckung des im Teil EP der
epitaktischen Schicht vorzusehenden Emitters und der Teil
Ni3 der Abdeckung eines abseits vom Emitter für die Basiselektrode vorzusehenden Bereichs an der Oberfläche des
n-dotierten Teils EP der epitaktischen Schicht dient.

An dem nicht abgedeckten Teil der Oberfläche des Teiles
EP der epitaktischen Schicht wird nun, wie aus Fig. 13
ersichtlich, der erste Dotierungsprozeß Dot1 gemäß der
Definition der Erfindung vorgenommen. Der Erfolg ist
eine $p^+$-dotierte Zone VB, die im wesentlichen der Zone
VB bei der ersten Variante des erfindungsgemäßen Verfahrens
(vgl. Fig. 8) entspricht. Im Unterschied zu der ersten
Variante reicht jedoch diese vom ersten Dotierungsprozeß
Dot 1 herrührende Zone VB nicht bis zu der für die Kontaktierung der Basis vorgesehene Stelle an der Oberfläche der epitaktischen Schicht EP, da diese von dem Teil Ni3 der ersten Dotierungsmaske bedeckt ist.

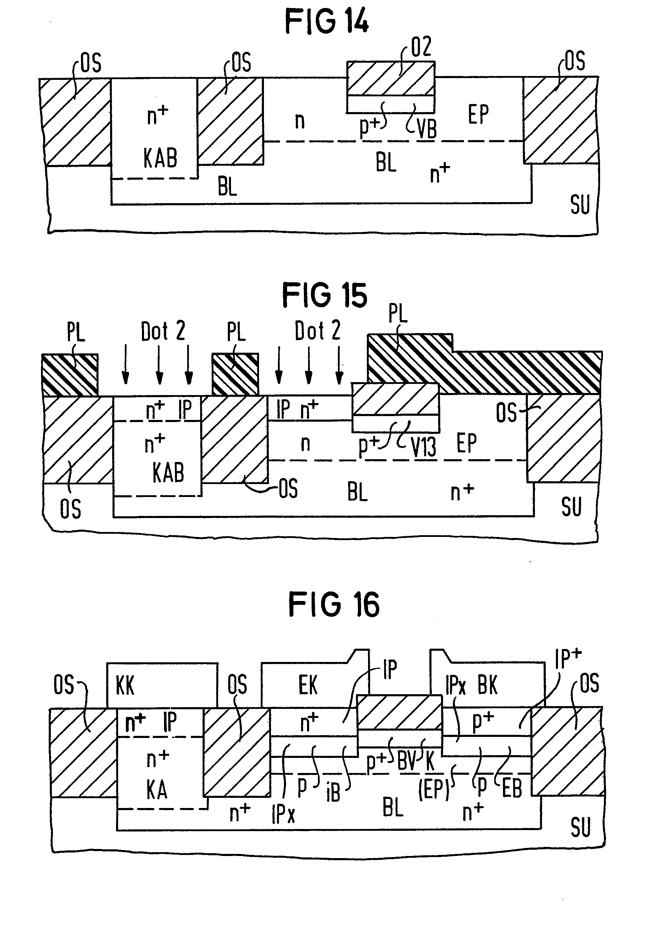

Die nunmehr vorliegende und in Fig. 13 dargestellte Anordnung wird nun zwecks Erstellung der zweiten Dotierungsmaske einem Oxydationsprozeß unter Verwendung der Teile Ni1, Ni2 und Ni3 der ersten Dotierungsmaske als Oxydationsmaske unterzogen. Anschließend werden die von der Nitridschicht abgedeckten Teile der Siliciumoberfläche selektiv freigelegt, so daß nunmehr die vorher von den Maskenteilen Ni1, Ni2 und Ni3 bedeckt gewesenen Teile der epitaktischen Schicht, d.h. der Kollektor-Kontaktierungsbereich KAB, der für die Aufnahme des Emitters und der für die Kontaktierung der Basis vorgesehene Bereich der Oberfläche der epitaktischen Schicht nunmehr freiliegen. Dagegen ist die Oberfläche der vom ersten Dotierungsprozeß Dot1 herrührenden $p^+$-dotierten Zone VB von der die zweite Dotierungsmaske O2 bildende Oxydschicht bedeckt. Dieser Zustand ist in Fig. 14 gezeigt.

Vor der Durchführung des zweiten Dotierungsprozesses Dot2 wird die Stelle an der Oberfläche der epitaktischen Schicht EP, an der vorher der Teil Ni3 der ersten Dotierungsmaske gewesen war, selektiv mit einer Implantierungsmaske PL aus Photolack abgedeckt, worauf die Emitterzone sowie eine weitere Verstärkung der Dotierung an der Oberfläche der Kollektor-Kontaktierungszone KAB in einem gemeinsamen Prozeß, also dem zweiten Dotierungsprozeß, erzeugt wurden. Die im Bereich EP aufgrund des Implantationsprozesses entstandenen $n^+$-dotierte Zone IP bildet die Grundlage des Emitters E, während die im Bereich KAB entstandene Zone IP eine weitere Verstärkung der $n^+$-Dotierung im Kontaktbereich KAB bildet. (Fig.15) Nach der Entfernung der Photolackmaske PL in der aus Fig. 15 ersichtlichen und nunmehr vorliegenden Struktur der Anordnung wird in einem dritten Dotierungsprozeß bei Anwesenheit der aus Oxyd bestehenden Teile der bei zweiten Dotierungsprozeß verwendeten Dotierungsmaske, also der Teile o2, sowie einer Abdeckung des Kollektorkontaktierungsbereiches KB und Emitterbereiches E mit einer aus Photolack bestehenden Maske die Dotierung des Basiskontaktierungsbereiches KB durch Implantation von Akzeptorionen erzeugt. Nach Entfernen dieser Photolackmaske wird bei Anwesenheit der aus Oxid bestehenden Dotierungsmaske $O_2$ die Dotierung der internen Basis IB durch Implantation von Akzeptorionen erzeugt. Die Aktivierung der durch Implantation eingebrachten Donatoren bzw. Akzeptoren kann nun in einem gemeinsamen Schritt, z. B. durch therm. Ausheilen erfolgen. Sie kann auch zur Optimierung der jeweiligen Dotierungsprofile in zwei Schritten, d. h. für Emitter- und Basiskontaktgebiete vor dem Einbringen der internen Basisdotierung und gesondert für diese nach der Implantation derselben erfolgen. Der Kollektor K, also der an die Basiszone IB, VB, KB angrenzende Teil des Kollektorbereiches KAB, BL, K ist durch den durch die beschriebenen Dotierungsprozesse nicht erfaßten Teilbereichs der n-dotierten epitaktischen Schicht EP gegeben.

Durch Anbringen der Basiselektrode BK, der Kollektorelektrode KK und der Emitterelektrode EK an den für sie vorgesehenen Stellen der Oberfläche der epitaktischen Schicht EP wird dann der Transistor in der aus Fig. 16 ersichtlichen Weise fertiggestellt. In Fig. 16 ist der Zustand unmittelbar nach der Emitterimplantation gezeigt.

Das soeben beschriebene Verfahren verwendet infolge der Anwesenheit der Photolackschicht PL als einen Teil der zweiten Dotierungsmaske das z. B. in der DE-PS 2 435 905 beschriebene und als Composed-Mask-Technik bekannte Verfahren.

16 Figuren
23 Patentansprüche

Patentansprüche

1.) Verfahren zum Herstellen einer monolithisch integrierten Halbleiterschaltung, bei dem ein unter Verwendung einer ersten Dotierungsmaske vorzunehmender erster Dotierungsprozeß und dann ein unter Verwendung einer zweiten Dotierungsmaske vorzunehmender zweiter Dotierungsprozeß an derselben Seite eines scheibenförmigen monokristallinen Halbleiterkörpers durchgeführt und dabei aus unterschiedlichem Material bestehende Dotierungsmasken verwendet werden, dadurch gekennzeichnet, daß in lateraler Beziehung die zweite Dotierungsmaske inbezug auf die erste Dotierungsmaske wenigstens zum Teil komplementär ausgebildet wird.

2.) Verfahren nach Anspruch 1, dadurch gekennzeichnet, daß wenigstens bei Verwendung eines scheibenförmigen Halbleiterkörpers aus monokristallinem Silicium als Material für die eine Dotierungsmaske Siliciumdioxyd und für die andere Dotierungsmaske Siliciumnitrid verwendet wird.

3.) Verfahren nach Anspruch 1 oder 2, dadurch gekennzeichnet, daß zwischen einer aus einem anderen Material als Siliciumdioxyd bestehenden Dotierungsmaske (Ni) und der Oberfläche des scheibenförmigen monokristallinen Halbleiterkörpers eine aus Siliciumdioxyd bestehende dünne Pufferschicht (O1) vorgesehen wird.

4.) Verfahren nach einem der Ansprüche 1 bis 3, dadurch gekennzeichnet, daß für den ersten Dotierungsprozeß (Dot1) eine aus Siliciumnitrid bestehende und für den zweiten Dotierungsprozeß (Dot2) eine aus Siliciumdioxyd bestehende Dotierungsmaske verwendet wird.

5.) Verfahren nach einem der Ansprüche 1 bis 4, dadurch gekennzeichnet, daß das Material für eine der beiden Dotierungsmasken durch chemische Behandlung, insbesondere durch Oxydation, der Oberfläche des monokristallinen Halbleiterplättchens erzeugt wird.

6.) Verfahren nach einem der Ansprüche 1 bis 5, <u>dadurch gekennzeichnet</u>, daß die zweite Dotierungsmaske (02) unter Verwendung der ersten Dotierungsmaske als Oxydations- und Ätzmaske hergestellt wird.

7.) Verfahren nach Anspruch 2 und 6, <u>dadurch gekennzeichnet</u>, daß als erste Dotierungsmaske (Ni) eine Maske aus Siliciumnitrid und als zweite Dotierungsmaske (02) eine Maske aus Siliciumdioxyd verwendet wird.

8.) Verfahren nach einem der Ansprüche 1 bis 7, <u>dadurch gekennzeichnet</u>, daß die beiden Dotierungsschritte (Dot1, Dot2) zu Erzeugung eines pn-Übergangs verwendet werden.

9.) Verfahren nach Anspruch 8, <u>dadurch gekennzeichnet</u>, daß der erste Dotierungsschritt (Dot1) mit einem den Leitungstyp des zu behandelnden Teiles der Oberfläche der monokristallinen Halbleiterscheibe hervorrufenden Aktivator und der zweite Dotierungsschritt mit einem den entgegengesetzten Leitungstyp hervorrufenden Aktivator erfolgt.

10.) Verfahren nach Anspruch 8, <u>dadurch gekennzeichnet</u>, daß der zweite Dotierungsschritt (Dot2) mit einem den Leitungstyp des zu behandelnden Teiles der Oberfläche der monokristallinen Halbleiterscheibe hervorrufenden Aktivator und der erste Dotierungsschritt (Dot1) mit einem den entgegengesetzten Leitungstyp erzeugenden Aktivator durchgeführt wird.

11.) Verfahren nach einem der Ansprüche 1 bis 10, <u>dadurch gekennzeichnet</u>, daß die für den zweiten Dotierungsprozeß

0054649

verwendete Dotierungsmaske (02) insbesondere in unveränderter Form als Dotierungsmaske für einen dritten Dotierungsprozeß eingesetzt und der dritte Dotierungsprozeß
mit einem den entgegengesetzten Leitungstyp zum Aktivator beim zweiten Dotierungsprozeß erzeugenden Aktivator
durchgeführt wird.

12.) Verfahren nach einem der Ansprüche 1 bis 11, dadurch
gekennzeichnet, daß die erste Dotierungsmaske (Ni) inselartig ausgestaltet wird.

13.) Verfahren zum Herstellen eines Transistors nach
einem der Ansprüche 1 bis 12, dadurch gekennzeichnet,
daß an der einen Seite einer monokristallinen Siliciumscheibe vom einen Leitungstyp (z.B. p-Typ) zunächst
wenigstens eine lokal begrenzte hochdotierte Zone (BL)
vom entgegengesetzten Leitungstyp (z.B. $n^+$-Typ) erzeugt
wird, daß dann die betreffende Seite der Siliciumscheibe
(Su) mit einer den Leitungstyp der lokal begrenzten Zone
jedoch mit geringerer Dotierungskonzentration wie diese
aufweisenden monokristallinen Siliciumschicht (z.B. vom
n-Typ) epitaktisch beschichtet wird und daß schließlich
diese epitaktische Siliciumschicht durch mit Siliciumdioxyd ausgefüllte und an die Oberfläche der ursprünglichen Siliumscheibe reichende Isolationsgräben (OS) derart unterteilt wird, daß der für den Transistor vorgesehen Bereich von solchen Isolationsgräben umrandet
und außerdem in zwei Teile getrennt ist, die lediglich
über die stärker dotierte Zone (BL) an der ursprünglichen Oberfläche der Siliciumscheibe (SU) mit einander
pn-Übergangsfrei in Verbindung stehen.

14.) Verfahren nach Anspruch 13, dadurch gekennzeichnet,
daß der eine der beiden dem zu erzeugenden Transistor
zugeteilten Bereiche (KAB, EP) der epitaktischen Siliciumschicht in einem vorgeschalteten Dotierungsprozeß
eine Verstärkung seiner Dotierung erhält, während der

0054649

andere Bereich (EP) der epitaktischen Siliciumschicht
mit einer Dotierungsmaske (SN) abgedeckt ist.

15.) Verfahren nach Anspruch 13 oder 14, dadurch gekennzeichnet, daß die beiden Dotierungsprozesse (Dot1, Dot2)
an der Oberfläche des für den Emitter und die Basis des
herzustellenden Transistors vorgesehenen Teiles (EP) des
für den Transistor vorgesehenen Bereiches der epitaktischen Siliciumschicht (KAB,EP) vorgenommen werden und
daß hierzu vorher der für die Kontaktierung des Kolektors
vorgesehene Bereich (KAB) mit einer $SiO_2$-Schicht (OK) durch
lokale Oxydation der Oberfläche dieses Bereiches (KAB) maskiert wird.

16.) Verfahren nach einem der Ansprüche 13 bis 15, dadurch
gekennzeichnet, daß die für den ersten Dotierungsprozeß
erforderliche erste Dotierungsmaske (In) aus der zur Erzeugung der oxydgefüllten Isolationsgräben (OS) als Oxydationsmaske verwendeten Siliciumnitridschicht (SN) gefertigt
wird.

17.) Verfahren nach einem der Ansprüche 13 bis 16, dadurch gekennzeichnet, daß die erste Oxydationsmaske (Ni)
an dem für die Erzeugung des Emitters (E) des Transistors
vorgesehenen Teil der epitaktischen Schicht (EP) aufgebracht wird.

18.) Verfahren nach Anspruch 17, dadurch gekennzeichnet,
daß wenigstens ein Teil des für die Kontaktierung der
herzustellenden Basiszone (IB) des Transistors vorgesehener Bereich von der ersten Dotierungsmaske (Ni) beim
ersten Dotierungsprozeß (Dot1) nicht bedeckt wird.

19.) Verfahren nach Anspruch 18, dadurch gekennzeichnet,
daß der erste Dotierungsprozeß (Dot1) für die Herstellung
der Basis-Kontaktierungszone (VB) verwendet wird.

0054649

20.) Verfahren nach Anspruch 19, dadurch gekennzeichnet, daß der zweite Dotierungsprozeß der Erzeugung der Emitterzone (E) und ein dritter Dotierungsprozeß der Erzeugung des an die Emitterzone (E) angrenzenden Teils (BI) der Basiszone dient und daß der zweite und der dritte Dotierungsprozeß mit der unveränderten zweiten Dotierungsmaske vorgenommen wird.

21.) Verfahren nach Anspruch 20., dadurch gekennzeichnet, daß der zweite Dotierungsprozeß der Erzeugung des an die Emitterzone (E) angrenzenden Teils (BI) der Basiszone und der mit der unveränderten zweiten Dotierungsmaske 02) vorzunehmende dritte Dotierungsprozeß der Erzeugung der Emitterzone (E) dient.

22.) Verfahren nach einem der Ansprüche 1 bis 21, dadurch gekennzeichnet, daß wenigstens ein mit der ersten und/oder der zweiten Dotierungsmaske (In bzw, 02) vorzunehmender Dotierungsprozeß als Ionenimplantationsprozeß durchgeführt wird.

23.) Verfahren nach einem der Ansprüche 15 bis 22, dadurch gekennzeichnet, daß die der Erzeugung der Basiszone (IB,VB,IP$^{*}$) dienenden Dotierungsprozesse derart gesteuert werden, daß der Basis-Kollektorübergang des Transistors abseits von der an der ursprünglichen Oberfläche des scheibenförmigen Siliciumkristalls (SU) erzeugten hochdotierten Zone (BL) verläuft.

**FIG 1**

**FIG 2**

**FIG 3**

## FIG 4

## FIG 5

## FIG 6

## FIG 7

## FIG 8

OS OK OS Ni Dot 1

n+ KAB

2 O1 p+ I

EP n

n+ BL

SU

p

## FIG 9

OS OK (OS) O2 2 O2 OS

n+ KAB

EP I p+ VB

n+ BL

SU

p

## FIG 10

OK Dot 2 O2 p+ VB OS

OS OS II n+ E

p+ IB

n+ KAB EB n

n+ BL

SU

p

## FIG 11

## FIG 12

## FIG 13

## FIG 14

OS

OS

O2

OS

$n^+$

KAB

BL

n

BL

$p^+$

VB

EP

$n^+$

SU

## FIG 15

PL

Dot 2

PL

Dot 2

PL

$n^+$ IP

IP $n^+$

OS

$n^+$

KAB

n

$p^+$

V13

EP

OS

OS

BL

$n^+$

SU

## FIG 16

OS

KK

OS

EK

IP

IPx BK

IP+

OS

$n^+$ IP

$n^+$

$p^+$

$n^+$

KA

P

iB

$p^+$ BV K

(EP)

P EB

$n^+$ IPx

BL

$n^+$

SU

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | EP - A - 0 013 317 (IBM)<br><br>* Seite 2, Zeilen 23-36; Seite 3; Figuren 1-4 * | 1-7,9,<br>12 |
| | -- | |
| A | US - A - 4 168 999 (FAIRCHILD)<br><br>* Spalten 3-6; Figuren 1-10 * | 1-23 |
| | -- | |
| A | US - A - 4 151 010 (IBM)<br><br>* Insgesamt * | 13-23 |
| | -- | |
| P | EP - A - 0 025 854 (IBM)<br><br>* Insgesamt * | 1-23 |
| | ---- | |

**KLASSIFIKATION DER ANMELDUNG (Int. Cl )**

H 01 L 21/00

**RECHERCHIERTE SACHGEBIETE (Int Cl )**

H 01 L 21

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstelit.

| Recherchenort | Abschlußdatum der Recherche | Prüfer |
|---|---|---|
| Den Haag | 23-03-1982 | PELSERS |

EPA form 1503.1   06.78